# EUROPEAN PATENT APPLICATION

(11) **EP 4 753 379 A1**
(43) Date of publication of application: **03.06.2026**
(21) Application number: 25209745.6
(22) Date of filing: 20.10.2025
(51) Int. Cl.: H05K 1/02, H05K 1/14, H05K 7/20, H05K 1/181

(54) **ELECTRONIC BOARD AND COMPUTING SYSTEM INCLUDING THE SAME**

(30) Priority: 27.11.2024 US 202463725801 P; 30.12.2024 KR 20240200938
(71) Applicant: Samsung Electronics Co., Ltd., Suwon-si, Gyeonggi-do 16677 (KR)
(72) Inventor: Bang, Byungwoo, 16678 Suwon-si, Gyeonggi-do (KR); Thielen, Casey Glenn, Mesa, AZ, 85215 (US); Francis, Praveen Koottate, Waltham, MA, 02453 (US); Lee, Wonseok, 16678 Suwon-si, Gyeonggi-do (KR); Hong, Young Jun, 16678 Suwon-si,Gyeonggi-do (KR)
(74) Representative: Grünecker Patent- und Rechtsanwälte PartG mbB

(57) **Abstract**

An electronic board 22 includes a board body 221 having a circuit formed therein, a plurality of computing devices 222 disposed at a position between a first distance D1 and a second distance D2 from one point O of the board body, and arranged radially around the one point, a plurality of networking devices 223 disposed at a position between the second distance D2 and a third distance D3 from the one point of the board body, and arranged radially around the one point, and a plurality of external connectors 224 arranged radially along a boundary of the board body, to which external cables interconnecting the electronic board and other electronic boards are configured to be connected.

## Description

### BACKGROUND

### 1. Field of the Invention

The following description relates to an electronic board and a computing system including the electronic board.

### 2. Description of Related Art

Amid frequent information exchange between processors and/or memories due to a problem of a large size of applications handled by a large-scale computing system, securing sufficient bandwidth may be important in cases where the performance of the applications is limited by input/output (I/O) bandwidth. **In** addition, a typical computing structure and method may not achieve efficient connections between computing infrastructure with a plurality of processors and/or memories provided therein and computing resources.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

The invention is what is claimed in the independent claims. Preferred embodiments are specified in the dependent claims.

In one or more general aspects, an electronic board includes a board body having a circuit formed therein, a plurality of computing devices disposed at a position between a first distance and a second distance from one point of the board body, and arranged radially around the one point, a plurality of networking devices disposed at a position between the second distance and a third distance from the one point of the board body, and arranged radially around the one point, and a plurality of external connectors arranged radially along a boundary of the board body, to which external cables interconnecting the electronic board and other electronic boards are configured to be connected.

The one point may be a center of the board body, and the board body may have a shape with point symmetry relative to the one point.

The plurality of computing devices may be disposed nearer to the one point than the plurality of networking devices, and the plurality of external connectors may be disposed farther from the one point than the plurality of networking devices.

The electronic board may include a heat release hole formed at the one point.

The electronic board may include a plurality of internal connectors disposed between the plurality of computing devices and the plurality of networking devices, and arranged radially around the one point, and an internal cable interconnecting a pair of internal connectors of the plurality of internal connectors.

Of the plurality of computing devices, a pair of computing devices disposed on opposite sides from the one point may be electrically connected by a cable fastened to an outer surface of the board body, and any one of the pair of computing devices and any one of the plurality of computing devices other than the pair of computing devices may be electrically connected by the circuit formed inside the board body.

Of the plurality of computing devices and the plurality of networking devices, some devices may be disposed on a front side of the board body and remaining devices may be disposed on a rear side of the board body.

Of the plurality of computing devices, some computing devices may be disposed on the front side of the board body and remaining computing devices may be disposed on the rear side of the board body.

The electronic board may include a computing wiring that connects the plurality of computing devices and is formed on either one of a front side and a rear side of the board body, and a networking wiring that connects the plurality of networking devices and is formed on a side, of the front side and the rear side of the board body, on which the computing wiring is not formed.

The board body may include a plurality of body layers stacked on top of each other and a via structure through one or more of the plurality of body layers, the electronic board may include a first computing crosswire that, of the plurality of computing devices, interconnects a first pair of computing devices disposed opposite each other relative to the one point and is formed in a first body layer of the plurality of body layers, and a second computing crosswire that, of the plurality of computing devices, interconnects a second pair of computing devices disposed opposite each other relative to the one point and is formed in a second body layer of the plurality of body layers, and either one of the first computing crosswire and the second computing crosswire may be connected to either one of the first pair of computing devices and the second pair of computing devices by the via structure.

The electronic board may include a first networking crosswire that, of the plurality of networking devices, interconnects a first pair of networking devices disposed opposite each other relative to the one point, and a second networking crosswire that, of the plurality of networking devices, interconnects a second pair of networking devices disposed opposite each other relative to the one point, wherein the first computing crosswire and the first networking crosswire may be formed at substantially the same height in the first body layer, and the second computing crosswire and the second networking crosswire may be formed at substantially the same height in the second body layer.

Any one of the computing crosswires may be formed on the same body layer as a networking crosswire that interconnects a pair of networking devices nearest respectively to a pair of computing devices interconnected by the one computing crosswire.

The board body may include a plurality of body layers stacked on top of each other and a via structure through one or more of the plurality of body layers, the electronic board may include a first networking crosswire that, of the plurality of computing devices, interconnects a first pair of networking devices disposed opposite each other relative to the one point and is formed in a first body layer of the plurality of body layers, and a second networking crosswire that, of the plurality of computing devices, interconnects a second pair of networking devices disposed opposite each other relative to the one point and is formed in a second body layer of the plurality of body layers, and either one of the first networking crosswire and the second networking crosswire may be connected to either one of the first pair of networking devices and the second pair of networking devices by the via structure.

One or more of the plurality of computing devices may include a central processing unit (CPU), and a plurality of graphics processing units (GPUs), wherein the CPU is disposed nearer to the one point than the plurality of GPUs.

The electronic board may include a cable hole through which the external cables are configured to pass, wherein the plurality of computing devices is disposed farther from the one point than the plurality of networking devices, and the plurality of external connectors is disposed along a circumferential direction of the cable hole.

The board body may have a regular polygonal shape, and the plurality of external connectors may be distributed in equal numbers along each side of the board body.

The electronic board may include a plurality of additional computing devices arranged radially around another point of the board body, and a plurality of additional networking devices arranged radially around the other point of the board body.

In one or more general aspects, a computing system may include a case having a receiving space formed therein, the electronic board and the other electronic boards, being disposed within the receiving space, and the external cables.

In one or more general aspects, an electronic board includes a board body having a shape with point symmetry of either one of a polygonal shape and a circular shape, a plurality of computing devices arranged along a circumferential direction of an imaginary first circle having a first radius relative to one point on the board body, a plurality of networking devices arranged along a circumferential direction of an imaginary second circle having a second radius relative to the one point on the board body, and a plurality of external connectors arranged along a circumferential direction of an imaginary third circle having a third diameter relative to the one point on the board body.

In one or more general aspects, a computing system includes a case having a receiving space formed therein, a plurality of electronic boards disposed within the receiving space, and a plurality of external cables interconnecting two or more of the plurality of electronic boards, wherein one or more of the plurality of electronic boards includes a board body having a circuit formed therein, a plurality of computing devices disposed at a position between a first distance and a second distance from one point of the board body, and arranged radially around the one point, a plurality of networking devices disposed at a position between the second distance and a third distance from the one point of the board body, and arranged radially around the one point, and a plurality of external connectors arranged radially along a boundary of the board body, to which one or more of the plurality of external cables is connected.

The computing system may include a cooling plate disposed between the plurality of electronic boards, the cooling plate may include a plate body having a cooling channel formed therein, an inlet port configured to receive a cooling fluid and direct the received cooling fluid into the cooling channel, and an outlet port configured to direct the cooling fluid from the cooling channel to the outside to discharge the cooling fluid to the outside, the cooling channel may include a first region overlapping the plurality of computing devices in a direction perpendicular to the plurality of electronic boards, and a second region overlapping the plurality of networking devices in the direction perpendicular to the plurality of electronic boards, and the cooling fluid may flow in sequential order from the inlet port, the first region, the second region, to the outlet port.

Other features and aspects will be apparent from the following detailed description, the drawings, and the claims.

### BRIEF DESCRIPTION OF THE DRAWINGS

FIG. 1 illustrates an example of a computing system according to one or more embodiments.
FIG. 2 illustrates an example of an electronic board according to one or more embodiments.
FIGS. 3, 4, and 5 illustrate examples of an electronic board according to one or more embodiments.
FIG. 6 illustrates an example of an electronic board according to one or more embodiments.
FIG. 7 illustrates an example of a computing system according to one or more embodiments.
FIG. 8 is a cross-sectional view of a cooling plate according to one or more embodiments.
FIG. 9 illustrates an example of an electronic board according to one or more embodiments.
FIG. 10 illustrates an example of an electronic board according to one or more embodiments.
FIG. 11 illustrates an example of an electronic board according to one or more embodiments.
FIG. 12 illustrates an example of an electronic board according to one or more embodiments.
FIG. 13 illustrates an example of an electronic board according to one or more embodiments.
FIG. 14 illustrates an example of an electronic board according to one or more embodiments.
FIG. 15 illustrates an example of an electronic board according to one or more embodiments.
FIG. 16 illustrates an example of an electronic board according to one or more embodiments.
FIG. 17 illustrates an example of an electronic board according to one or more embodiments.
FIG. 18 illustrates an example of an electronic board according to one or more embodiments.
FIG. 19 illustrates an example of an electronic board according to one or more embodiments.

Throughout the drawings and the detailed description, unless otherwise described or provided, the same or like drawing reference numerals may be understood to refer to the same or like elements, features, and structures. The drawings may not be to scale, and the relative size, proportions, and depiction of elements in the drawings may be exaggerated for clarity, illustration, and convenience.

### DETAILED DESCRIPTION

The following detailed description is provided to assist the reader in gaining a comprehensive understanding of the methods, apparatuses, and/or systems described herein. However, various changes, modifications, and equivalents of the methods, apparatuses, and/or systems described herein will be apparent after an understanding of the disclosure of this application. For example, the sequences of operations described herein are merely examples, and are not limited to those set forth herein, but may be changed as will be apparent after an understanding of the disclosure of this application, with the exception of operations necessarily occurring in a certain order. Also, descriptions of features that are known after an understanding of the disclosure of this application may be omitted for increased clarity and conciseness.

The features described herein may be embodied in different forms and are not to be construed as being limited to the examples described herein. Rather, the examples described herein have been provided merely to illustrate some of the many possible ways of implementing the methods, apparatuses, and/or systems described herein that will be apparent after an understanding of the disclosure of this application.

The terminology used herein is for describing various examples only and is not to be used to limit the disclosure. The articles "a," "an," and "the" are intended to include the plural forms as well, unless the context clearly indicates otherwise. As non-limiting examples, terms "comprise" or "comprises," "include" or "includes," and "have" or "has" specify the presence of stated features, numbers, operations, members, elements, and/or combinations thereof, but do not preclude the presence or addition of one or more other features, numbers, operations, members, elements, and/or combinations thereof, or the alternate presence of an alternative stated features, numbers, operations, members, elements, and/or combinations thereof. Additionally, while one embodiment may set forth such terms "comprise" or "comprises," "include" or "includes," and "have" or "has" to specify the presence of stated features, numbers, operations, members, elements, and/or combinations thereof, other embodiments may exist where one or more of the stated features, numbers, operations, members, elements, and/or combinations thereof are not present.

Throughout the specification, when a component, element, or layer is described as being "on," "connected to," "coupled to," or "joined to" another component, element, or layer, it may be directly (e.g., in contact with the other component, element, or layer) "on," "connected to," "coupled to," or "joined to" the other component, element, or layer, or there may reasonably be one or more other components, elements, or layers intervening therebetween. When a component, element, or layer is described as being "directly on," "directly connected to," "directly coupled to," or "directly joined to" another component, element, or layer, there can be no other components, elements, or layers intervening therebetween. Likewise, expressions, for example, "between" and "immediately between" and "adjacent to" and "immediately adjacent to" may also be construed as described in the foregoing.

Although terms such as "first," "second," and "third", or A, B, (a), (b), and the like may be used herein to describe various members, components, regions, layers, or sections, these members, components, regions, layers, or sections are not to be limited by these terms. Each of these terminologies is not used to define an essence, order, or sequence of corresponding members, components, regions, layers, or sections, for example, but may be used merely to distinguish the corresponding members, components, regions, layers, or sections from other members, components, regions, layers, or sections. Thus, a first member, component, region, layer, or section referred to in the examples described herein may also be referred to as a second member, component, region, layer, or section without departing from the teachings of the examples.

As used herein, the term "and/or" includes any one and any combination of any two or more of the associated listed items. The phrases "at least one of A, B, and C," "at least one of A, B, or C," and the like are intended to have disjunctive meanings, and these phrases "at least one of A, B, and C," "at least one of A, B, or C," and the like also include examples where there may be one or more of each of A, B, and/or C (e.g., any combination of one or more of each of A, B, and C), unless the corresponding description and embodiment necessitates such listings (e.g., "at least one of A, B, and C") to be interpreted to have a conjunctive meaning.

Unless otherwise defined, all terms, including technical and scientific terms, used herein have the same meaning as commonly understood by one of ordinary skill in the art to which this disclosure pertains and based on an understanding of the disclosure of the present application. Terms, such as those defined in commonly used dictionaries, are to be interpreted as having a meaning that is consistent with their meaning in the context of the relevant art and the disclosure of the present application and are not to be interpreted in an idealized or overly formal sense unless expressly so defined herein. The use of the term "may" herein with respect to an example or embodiment, e.g., as to what an example or embodiment may include or implement, means that at least one example or embodiment exists where such a feature is included or implemented, while all examples are not limited thereto. The use of the terms "example" or "embodiment" herein have a same meaning (e.g., the phrasing "in one example" has a same meaning as "in one embodiment," and "one or more examples" has a same meaning as "in one or more embodiments").

Hereinafter, example embodiments will be described in detail with reference to the accompanying drawings. When describing the example embodiments with reference to the accompanying drawings, like reference numerals refer to like components and a repeated description related thereto will be omitted.

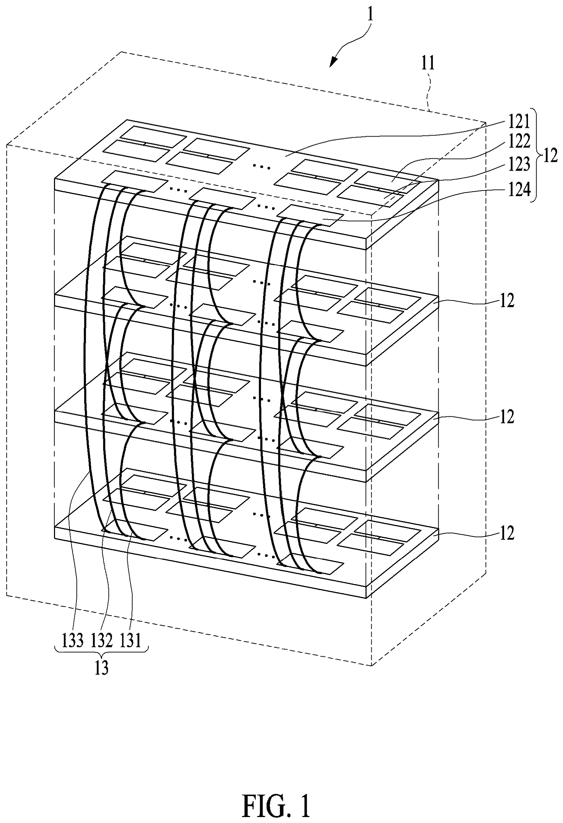

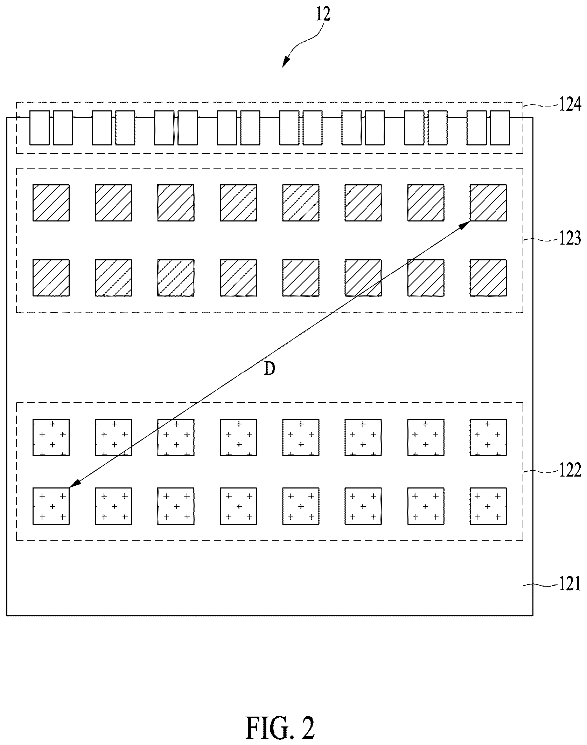

FIG. 1 illustrates an example of a computing system according to one or more embodiments. FIG. 2 illustrates an example of an electronic board according to one or more embodiments.

Referring to FIGS. 1 and 2, a computing system 1 of one or more embodiments may be a system that handles various workloads. For example, the computing system 1 may perform various tasks including, for example, a generative artificial intelligence (Al)-related task, and may be provided in a structure in which various semiconductor elements are highly integrated with a high density to meet high-level requirements. To meet the requirements, the computing system 1 of one or more embodiments may be used in consideration of the increased system size, weight, and/or heat generation, and the length and/or weight of network cables connecting numerous components. For example, the computing system 1 may be a server system. In one or more embodiments, the computing system 1 may include a case 11 having a receiving space formed therein, a plurality of electronic boards 12 disposed in the receiving space of the case 11, and a plurality of external cables 13 interconnecting at least two of the plurality of electronic boards 12.

The plurality of electronic boards 12 may be disposed, for example, in a direction perpendicular to the electronic boards 12 inside the case 11. For example, the plurality of electronic boards 12 may be disposed along a height direction of the case 11. However, it should be appreciated that the plurality of electronic boards 12 may also be disposed along a width direction of the case 11, unlike what is shown. Of the plurality of electronic boards 12, at least one electronic board 12 may include a board body 121, a computing device 122, a networking device 123, and an external connector 124.

The board body 121 may have a circuit formed therein. The board body 121 may provide a space in which electronic components (e.g., the computing device 122, the networking device 123, and/or the external connector 124) are installed, and the circuit formed therein may electrically connect at least some of the electronic components installed on the board body 121.

The computing device 122 may perform computational processing on received information. The computing device 122 may include, for example, a processor, a central processing unit (CPU), a graphics processing unit (GPU), a memory, an interface, a power management device, and/or other peripherals. The computing device 122 may be, for example, a system on a chip (SoC), which is provided in a form in which multiple functions are integrated into a single chip. For example, a plurality of computing devices 122 may be disposed in a form in which they are gathered in a first region on the board body 121, as shown in FIG. 2. For example, at least some of the plurality of computing devices 122 may be connected via cables or internal circuits of the board body 121 such that they exchange signals directly without passing through other electronic components. For example, the plurality of computing devices 122 may be connected to mutually exchange signals via maximal two or fewer intermediate nodes in a two-hop manner.

The networking device 123 may perform functions of transmitting, distributing, and managing data packets. The networking device 123 may include, for example, a switch. For example, a plurality of networking devices 123 may be disposed in a form in which they are gathered in a second region on the board body 121, as shown in FIG. 2. For example, the networking device 123 may perform a function of transferring signals between the computing device 122 and the external connector 124. For example, at least some of the plurality of networking devices 123 may be connected via cables or internal circuits of the board body 121 such that they exchange signals directly without passing through other electronic components. For example, the plurality of networking devices 123 may be connected to mutually exchange signals via maximal two or fewer intermediate nodes in the two-hop manner.

The external connector 124 may be connected to an external cable 13 that interconnects an electronic board 12 and another electronic board 12. The external connector 124 may be disposed, for example, on one side of the respective sides of the board body 121 adjacent to the second region in which the networking device 123 is disposed. As the external connector 124 is disposed nearer to the networking device 123 than to the computing device 122, the computing system 1 of one or more embodiments may improve a signal transfer speed between the different electronic boards 12. For example, as shown in FIG. 2, a plurality of external connectors 124 may be disposed on one side of the board body 121, the plurality of networking devices 123 may be disposed near the plurality of external connectors 124, and the plurality of computing devices 122 may be disposed on the opposite side of the plurality of external connectors 124 relative to the plurality of networking devices 123.

The external cable 13 may interconnect a plurality of different electronic boards 12. For example, the external cable 13 may include a first cable 131 connecting a pair of electronic boards 12 that are adjacent to each other among the plurality of electronic boards 12, a second cable 132 connecting a pair of electronic boards 12 disposed on both sides of one of the electronic boards 12, and a third cable 133 connecting a pair of electronic boards 12 disposed on both sides of two or more of the electronic boards 12. For example, all the electronic boards 12 disposed in the computing system 1 may be directly connected without intermediate nodes.

The structure shown in FIG. 2 may improve an information transfer speed between electronic components of the same type and distribute a specific task or computation into multiple nodes or processors to process them in parallel, thereby greatly improving the computation speed. However, when a large number of computing devices 122 and networking devices 123 are disposed on a single board body 121 as shown in FIG. 2, a typical electronic board 12 may have a disadvantage in that a distance D between a specific computing device 122 and a specific networking device 123 may increase greatly. This increase and deviation in distance D may cause delays, noise, voltage drops, power consumption, and signal interference in signals transferred between the electronic components of the typical electronic board, and, in compensating for these, the typical electronic board may require a clock buffer to distribute or amplify a clock signal into multiple outputs. Further, when a large number of external cables 13 are disposed intensively on one side of the board body 121, an external load to be applied to the typical electronic board 12 may concentrate onto one side of the typical electronic board, which may reduce the durability of the typical electronic board 12. The example embodiments described below may reduce such disadvantages in the typical electronic board.

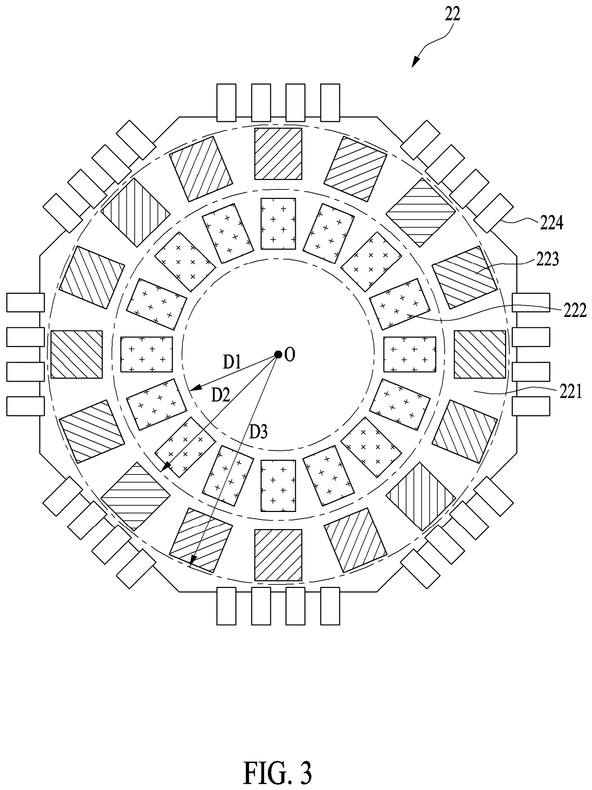

FIGS. 3, 4, and 5 illustrate examples of an electronic board according to one or more embodiments.

Referring to FIG. 3, an electronic board 22 of one or more embodiments may include a board body 221, a computing device 222, a networking device 223, and an external connector 224.

The board body 221 may be provided in a circular (e.g., regular circle or ellipse) or polygonal (e.g., regular polygon) shape, for example. For example, the board body 221 may be provided in a shape with point symmetry (or a "point-symmetric shape" herein) (e.g., circle, square, pentagon, hexagon, heptagon, octagon, etc.) with one point O at the center thereof. For example, the board body 221 may have an equilateral octagonal shape, as shown in FIGS. 3, 4, and 5.

A plurality of computing devices 222 may be disposed at a position between a first distance D1 and a second distance D2 from the point O of the board body 221. For example, the plurality of computing devices 222 may be disposed along a circumferential direction of an imaginary first circle having a first radius with respect to the point O on the board body 221. The point O may be, for example, the center of the board body 221. The plurality of computing devices 222 may be disposed radially around the point O. For example, the plurality of computing devices 222 may be spaced apart from each other at equidistant intervals. This arrangement and structure may enable designing that allows a pair of computing devices 222 spaced apart farthest among the plurality of computing devices 222 to have a distance therebetween that is approximately twice the first radius described above. Therefore, by a connecting distance between the plurality of computing devices 222 that is direct and short as described above, the electronic board 22 of one or more embodiments may increase data transfer speed and reduce signal delays. Further, as described below, the electronic board 22 of one or more embodiments may also have an even distribution of the networking devices 223 and the external connectors 224 that transmit and receive information to and from the computing devices 222, around the computing devices 222, and may also enable an even distribution of network traffic.

A plurality of networking devices 223 may be disposed at a position between the second distance D2 and a third distance D3 from the one point O on the board body 221. For example, the plurality of networking devices 223 may be disposed along a circumferential direction of an imaginary second circle having a second radius with respect to the point O on the board body 221. The plurality of networking devices 223 may be disposed radially around the point O. For example, the plurality of networking devices 223 may be spaced apart from each other at equidistant intervals. For example, the plurality of networking devices 223 may be disposed along a circumferential direction of the plurality of computing devices 222. For example, the second distance D2 may be greater than the first distance D1, and the third distance D3 may be greater than the second distance D2. In this case, the plurality of networking devices 223 may be disposed along an outer circumferential direction of the plurality of computing devices 222. This arrangement and structure of the electronic board 22 of one or more embodiments may shorten a distance between the plurality of computing devices 222 and may simplify or reduce a data transfer path along which data is transmitted from the computing device 222 to the external connector 224, or vice versa, via the network device 223, thereby increasing the data transfer speed and reducing the signal delays.

A plurality of external connectors 224 may be disposed radially along a boundary (e.g., an outer boundary) of the board body 221. For example, the plurality of external connectors 224 may be disposed along a circumferential direction of an imaginary third circle having a third diameter with respect to the one point O on the board body 221. For example, the plurality of external connectors 224 may be evenly distributed in equal numbers on both sides from the one point O by point-symmetric arrangement. For example, the plurality of external connectors 224 may be distributed in equal numbers along the respective sides of the board body 221. When a large number of electronic boards 22 are to be directly connected to each other, external cables (e.g., see 13 in FIG. 1) that are to be installed for each electronic board 22 may weigh hundreds of kilograms (kg) in some cases. In this case, it may be challenging for a computing system including typical electronic boards to support such a weight with external connectors disposed on only one side of the electronic boards. However, the arrangement and configuration of the electronic board 22 of one or more embodiments described above may reduce the concentration of the weight of the external connectors 224 and the external cables (e.g., see 13 in FIG. 1) connected thereto on any one side of the board body 221, and may improve the durability of the electronic board 22, thereby reducing the thickness of the board body 221 and/or diversifying the choice of materials that form the board body 221. For example, the plurality of external connectors 224 may be disposed along a circumferential direction of the plurality of networking devices 223. For example, the third distance D3 may be greater than the second distance D2. In this case, the plurality of external connectors 224 may be disposed along an outer circumferential direction of the plurality of networking devices 223. This arrangement and structure of the electronic board 22 of one or more embodiments may allow the external connectors 224 to be disposed along the outer boundary of the board body 221, thereby providing sufficient length (or space) for the external connectors 224 to be installed and reducing the challenge of the external connectors 224 being concentrated in only a few small areas.

**In** one or more embodiments, the plurality of computing devices 222 may be disposed nearer to the point O than the plurality of networking devices 223, and the plurality of external connectors 224 may be disposed farther from the point O than the plurality of networking devices 223. For example, the plurality of networking devices 223 may be disposed between the plurality of computing devices 222 and the plurality of external connectors 224, and may be disposed radially around the point O.

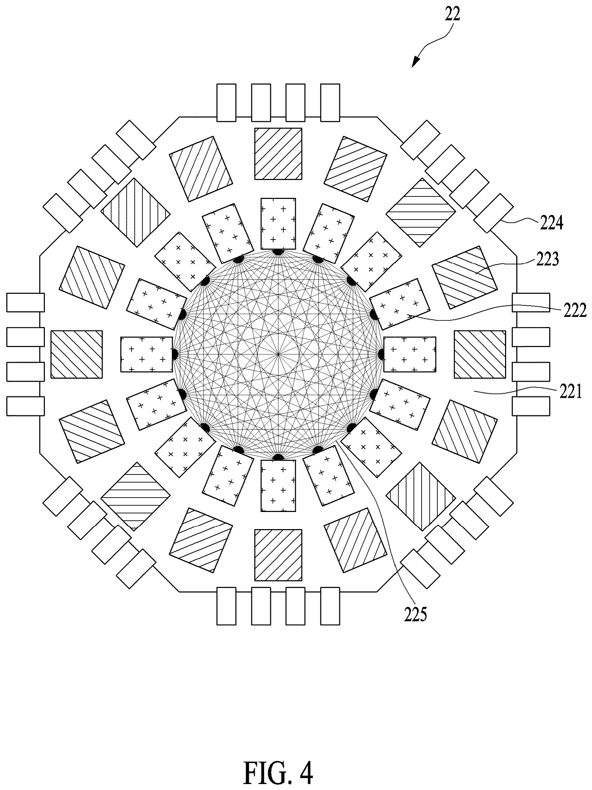

Referring to FIG. 4, the plurality of computing devices 222 may be connected to each other by a first wiring 225. For example, each computing device 222 may be directly connected to the remaining computing devices 222 via the first wiring 225. For example, each computing device 222 may be directly connected to all the remaining computing devices 222 one to one. The arrangement and configuration of the electronic board 22 of one or more embodiments described above may allow the plurality of computing devices 222 to process tasks in parallel (i.e., parallel processing) simultaneously, thereby increasing data processing speed and facilitating processing even a task with a high computing amount. Alternatively, some of a plurality of pairs of computing devices 222 may be directly connected, while others may be connected in a two-hop manner such that they are connected to exchange signals via maximal two or fewer intermediate nodes. This arrangement and configuration of the electronic board 22 of one or more embodiments may reduce the first wiring 225 in number, thereby simplifying the design of the electronic board 22. The first wiring 225 may also be referred to herein as "computing wiring."

For example, some of the plurality of pairs of computing devices 222 may be connected by cables installed on an outer surface of the board body 221, and the remaining of the plurality of pairs of computing devices 222 may be connected by an internal wiring formed in the board body 221. This wiring structure of the electronic board 22 of one or more embodiments in which internal circuits and cables are combined may improve the degree of freedom in designing circuitry in the electronic board 22. For example, of the plurality of computing devices 222, a pair of computing devices 222 disposed on opposite sides with respect to one point may be electrically connected via a cable fastened to the outer surface of the board body 221. For example, any one of the pair of computing devices 222 described above, and one computing device 222 of the plurality of computing devices 222 other than the pair of computing devices 222 described above, may be electrically connected by a circuit formed inside the board body 221. This structure may, when implementing internal circuits, implement a wiring that is highly likely to interfere with other circuits (e.g., a wiring that interconnects a pair of computing devices 222 disposed on opposite sides with respect to the one point). Therefore, by using cables instead of the internal circuits, the electronic board 22 of one or more embodiments may greatly improving the degree of freedom in implementing the internal circuits and accordingly shortening the length of the circuits.

**It** should be appreciated that, unless otherwise noted, the above-described connection schemes and structures between the plurality of computing devices 222 may be equally applicable to other electronic components (e.g., the networking devices 223 and the external connectors 224) disposed on the electronic board 22.

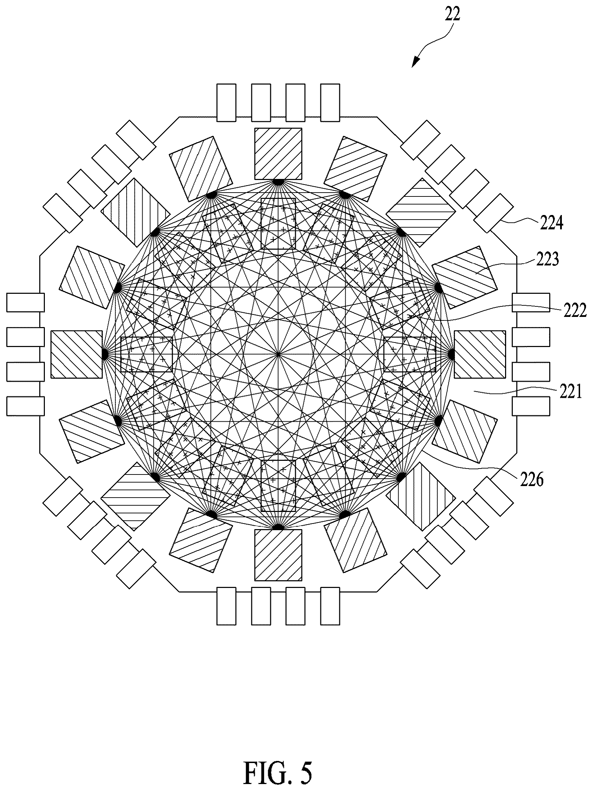

Referring to FIG. 5, the plurality of networking devices 223 may be connected to each other by a second wiring 226. For example, each networking device 223 may be directly connected to the remaining networking devices 223 via the second wiring 226. For example, each networking device 223 may be directly connected to all the remaining networking devices 223 one to one. This arrangement and configuration of the electronic board 22 of one or more embodiments may reduce a potential data bottleneck on each networking device 223 and may accordingly increase the data processing speed, thereby facilitating processing even a task with a high computing amount. The second wiring 226 may also be referred to herein as "networking wiring."

Although not shown, a wiring may also be formed between the plurality of computing devices 222 and the plurality of networking devices 223. For example, each computing device 222 may be directly connected to one networking device 223 nearest to the computing device 222, or may be directly connected to two or more networking devices 223 within a certain distance from the computing device 222. For example, each computing device 222 may be directly connected to all the networking devices 223. It should be appreciated that, unless otherwise noted, the above-described connection schemes and structures may also be applied between electronic components (e.g., the networking devices 223 and the external connectors 224) disposed on the board body 221. For example, all the electronic components disposed on the board body 221 may be connected, either directly or in a two-hop manner, such that they exchange signals through maximal two or fewer intermediate nodes. The radial structure of one or more embodiments may, even with such multiple connection methods, enable designing that may prevent the distance between the electronic components from excessively increasing.

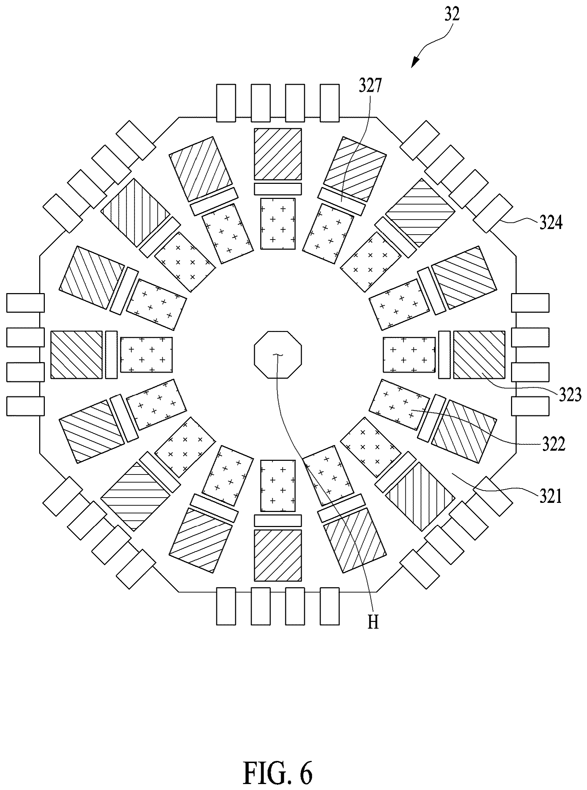

FIG. 6 illustrates an example of an electronic board according to one or more embodiments.

Referring to FIG. 6, an electronic board 32 of one or more embodiments may include a board body 321, a computing device 322, a networking device 323, an external connector 324, and an internal connector 327.

**In** one or more embodiments, a plurality of computing devices 322 may be disposed radially around one point O of the electronic board 32, and the electronic board 32 may include a hole H formed at the point O. The hole H may allow heat generated by the computing device 322 to be more readily released to the outside. The hole H may also be referred to herein as a "heat release hole." For example, when the plurality of computing devices 322 is disposed near the center of the electronic board 32, the heat generated by the plurality of computing devices 322 may be released through the hole H, in addition to an outer boundary of the electronic board 32, and thus the electronic board 32 of one or more embodiments may improve the heat dissipation efficiency of the electronic board 32. For example, in the case of a structure in which a plurality of electronic boards 32 are stacked, arranging holes H formed respectively on the electronic boards 32 to be aligned with each other may improve the heat dissipation efficiency.

**In** one or more embodiments, a plurality of internal connectors 327 may be disposed between the plurality of computing devices 322 and a plurality of networking devices 323, and may be disposed radially around the point O. For example, of the plurality of internal connectors 327, a pair of internal connectors 327 may be interconnected by an internal cable. For example, the internal cable may include a high-speed interconnect cable (e.g., a SlimSAS cable). Such a high-density interconnect cable may be used to connect between the plurality of computing devices 322 and/or the plurality of networking devices 323. For example, the internal connector 327 may be directly connected to one computing device 322 and/or one networking device 323 that is nearest to the internal connector 327, or may be directly connected to a plurality of computing devices 322 and/or networking devices 323 that are within a certain distance from the internal connector 327. This structure may enable a signal transfer between a plurality of electronic components (e.g., the computing device 322 and/or the plurality of networking devices 323) using the same internal connector 327, thereby simplifying the wiring of the electronic board 32.

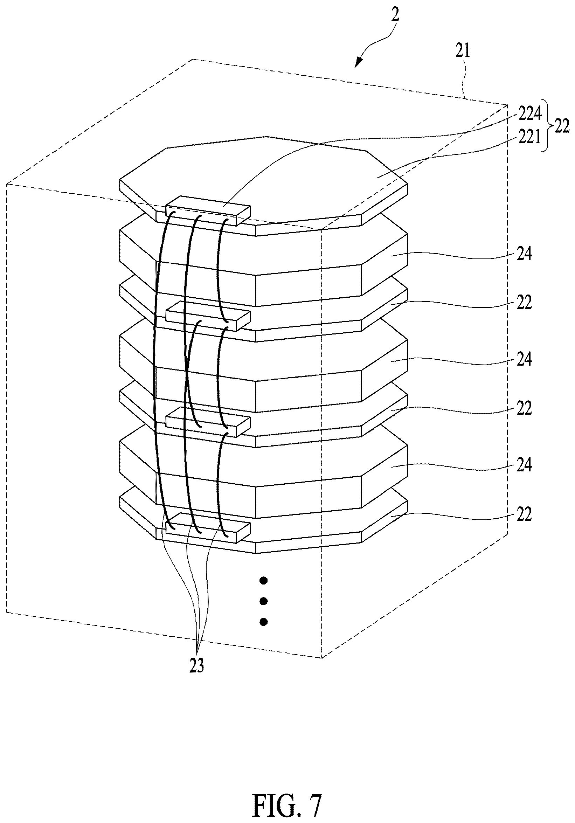

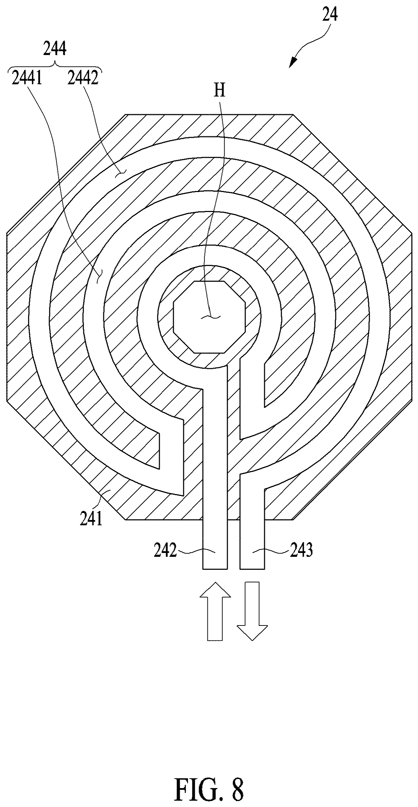

FIG. 7 illustrates an example of a computing system according to one or more embodiments. FIG. 8 is a cross-sectional view of a cooling plate according to one or more embodiments.

Referring to FIGS. 7 and 8, a computing system 2 of one or more embodiments may include a case 21, an electronic board 22, an external cable 23, and a cooling plate 24.

The electronic board 22 may include a board body 221, a computing device (e.g., the computing device 222 in FIG. 3), a networking device (e.g., the networking device 223 in FIG. 3), and an external connector 224. It should be appreciated that, for ease of description, the computing device and the networking device are not shown in FIG. 7, and the external connector 224 and the external cable 23 connected thereto are only partially shown. For example, the external connector 224 and the external cable 23 connected thereto may be installed on each side of the board body 221.

For example, a plurality of electronic boards 22 may be disposed in a direction perpendicular to the electronic board 22 and may have the same shape. For example, arranging respective sides of the plurality of electronic boards 22 to be parallel to each other may shorten the length of the external cable 23.

The cooling plate 24 may be disposed between the plurality of electronic boards 22 to cool the heat generated by electronic components installed on the electronic boards 22. For example, the cooling plate 24 may be disposed between a pair of electronic boards 22 adjacent to each other among the plurality of electronic boards 22. For example, the cooling plate 24 may be secured to the electronic components disposed on the electronic board 22 with a thermally conductive adhesive.

For example, the cooling plate 24 may cool the electronic board 22 using a cooling fluid circulating therein. The cooling plate 24 may include a plate body 241 having a cooling channel 244 formed therein, an inlet port 242 that receives a cooling fluid and directs it into the cooling channel 244, and an outlet port 243 that directs the cooling fluid from the cooling channel 244 to the outside to be discharged thereto. For example, in a case where each of the plurality of electronic boards 22 has a hole formed therein, the cooling plate 24 may have a hole corresponding thereto.

The cooling channel 244 may include a first region 2441 overlapping a plurality of computing devices (e.g., the computing devices 222 in FIG. 3) in a direction perpendicular to the plurality of electronic boards 22, and a second region 2442 overlapping a plurality of networking devices (e.g., the networking devices 223 in FIG. 3) in the direction perpendicular to the plurality of electronic boards 22. For example, the cooling fluid may flow in the order of from the inlet port 242, to the first region 2441, to the second region 2442, and to the outlet port 243, as shown in FIG. 8. According to this flow order, the cooling fluid introduced into the cooling plate 24 may first cool the computing device with a relatively great amount of generated heat on the electronic board 22, and then cool other electronic components with a relatively small amount of generated heat. Thus, the cooling plate 24 of one or more embodiments may improve the cooling efficiency while equalizing the temperature distribution within the electronic board 22. **It** should be appreciated that, although FIGS. 7 and 8 illustrate an example case where the first region 2441 is positioned near the center of the cooling plate 24, the first region 2441 may also be designed to be positioned near an outer boundary of the cooling plate 24 depending on the position of the computing device. That is, it should be appreciated that the inlet port 242 and the outlet port 243 shown in FIG. 8 may be interchangeable.

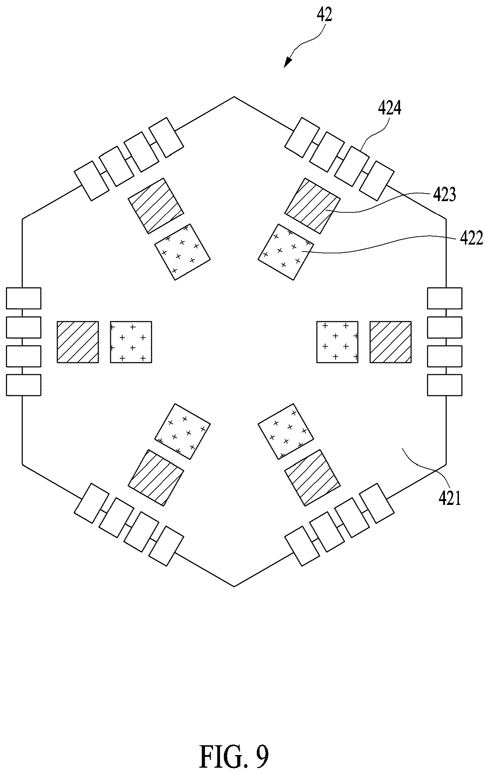

FIG. 9 illustrates an example of an electronic board according to one or more embodiments.

Referring to FIG. 9, an electronic board 42 of one or more embodiments may include a board body 421, a computing device 422, a networking device 423, and an external connector 424.

**In** one or more embodiments, the board body 421 may have a hexagonal (e.g., regular hexagonal) shape. For example, the computing device 422 and the networking device 423 may be arranged radially from a center of the board body 421 to each side of the board body 421. For example, the external connector 424 may be disposed on each side of the board body 421 and arranged radially to the center of the board body 421. It should be appreciated by those of ordinary skill in the art that, although computing devices 422 and networking devices 423 are each shown as being disposed in equal numbers on each side of the board body 421, there may be a plurality of them.

However, it should also be appreciated that the shape of the board body 421 is not necessarily limited to a hexagon but may be a circle, ellipse, or polygon (e.g., triangle, square, pentagon, hexagon, and the like). Hereinafter, in the case of a rectangular board body 421, various examples of wiring that connects electronic components, formed inside the board body 421, will be described. The wiring structures described below may be equally or similarly applicable to other example embodiments, unless otherwise noted.

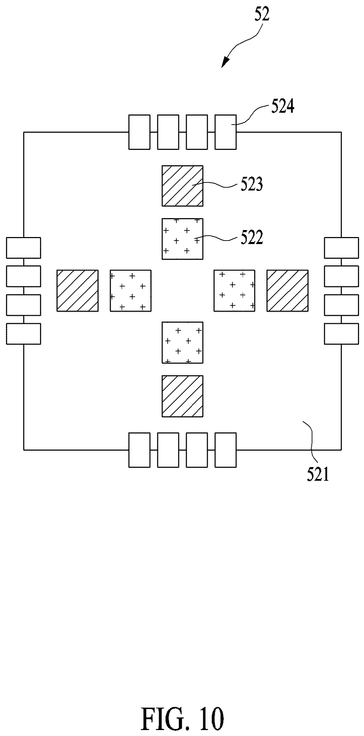

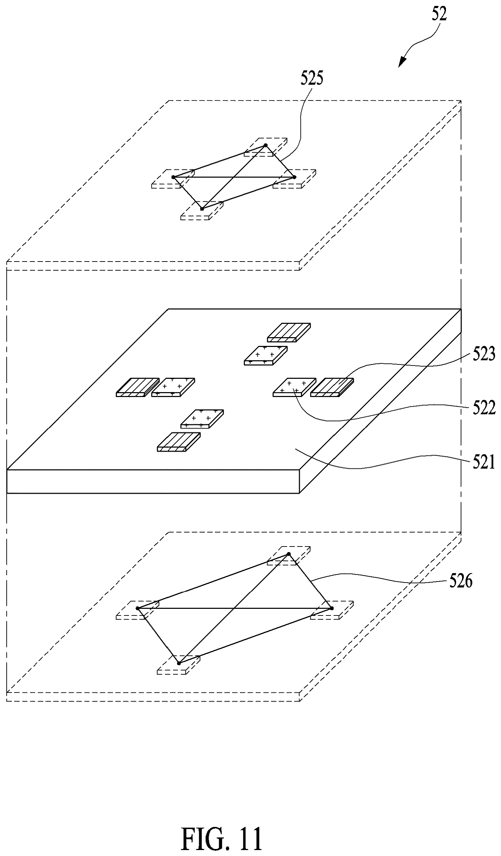

FIG. 10 illustrates an electronic board according to one or more embodiments, and FIG. 11 illustrates an electronic board according to one or more embodiments.

Referring to FIGS. 10 and 11, an electronic board 52 of one or more embodiments may include a board body 521, a computing device 522, a networking device 523, an external connector 524, a first wiring 525, and a second wiring 526.

In one or more embodiments, a plurality of computing devices 522 and a plurality of networking devices 523 may be disposed on the same side (e.g., front) of both sides of the board body 521. For example, the first wiring 525 connecting the plurality of computing devices 522 may be disposed on a first side (e.g., front) of the two sides of the board body 521, and the second wiring 526 connecting the plurality of networking devices 523 may be disposed on a second side (e.g., rear) of the two sides of the board body 521. For example, a computing wiring (e.g., the first wiring 525) may connect a plurality of computing devices and may be formed on the front or rear of a board body, and a networking wiring (e.g., the second wiring 526) may connect a plurality of networking devices and may be formed on the front or rear of the board body that does not have the computing wiring. This separation of positions of different types of wiring may facilitate configuration of the wiring of the electronic board 52 and reduce or minimize the challenge that bilateral signals may interfere with each other.

For example, of a plurality of wirings, some intersecting wirings may be formed in different layers by replacing them with cables attached to an outer surface of the board body 521 or forming the board body 521 using a plurality of layers and a via structure through at least some of the layers.

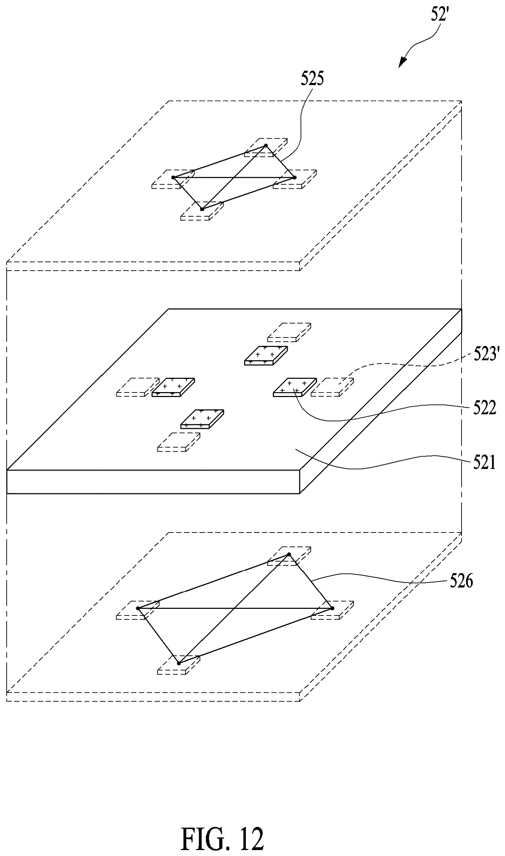

FIG. 12 illustrates an example of an electronic board according to one or more embodiments.

Referring to FIG. 12, an electronic board 52' of one or more embodiments may include a board body 521, a computing device 522, a networking device 523', an external connector (see 524 in FIG. 10), a first wiring 525, and a second wiring 526.

In one or more embodiments, some devices of a plurality of computing devices 522 and a plurality of networking devices 523' may be disposed on the front of the board body 521, while the remaining devices may be disposed on the rear of the board body 521. This structure of the electronic board 52' of one or more embodiments may reduce the number of electronic components to be disposed on one side of the board body 521, thereby improving the degree of freedom in designing and, in some cases, reducing the number of vias required to form circuits inside the board body 521.

For example, as shown in FIG. 12, the types of devices disposed on both sides of the board body 521 may be different. That is, the plurality of computing devices 522 may be disposed on one side of the board body 521, and the plurality of networking devices 523' may be disposed on the other side of the board body 521. It should be appreciated that this is only an example.

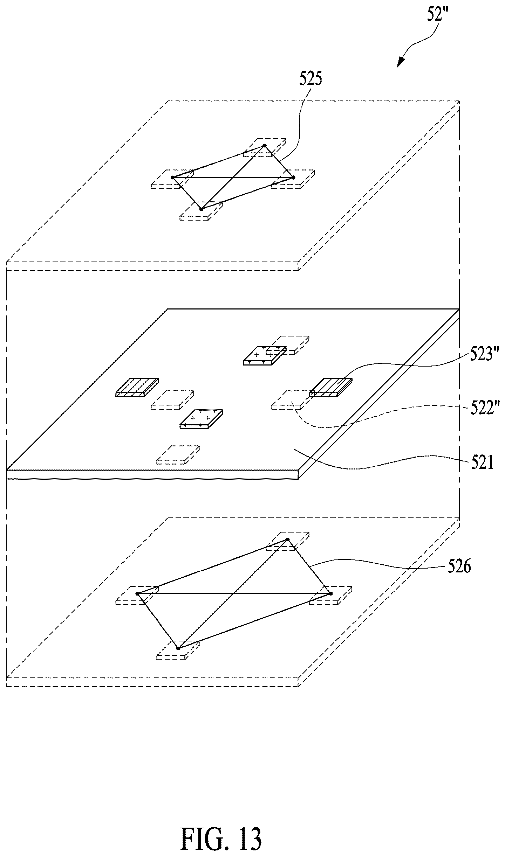

FIG. 13 illustrates an example of an electronic board according to one or more embodiments.

Referring to FIG. 13, an electronic board 52" of one or more embodiments may include a board body 521, a computing device 522", a networking device 523", an external connector (see 524 in FIG. 10), a first wiring 525, and a second wiring 526.

In one or more embodiments, some devices of a plurality of computing devices 522" and a plurality of networking devices 523" may be disposed on the front of the board body 521, while the remaining devices may be disposed on the rear of the board body 521.

For example, of the plurality of computing devices 522", some computing devices 522" may be disposed on the front of the board body 521, and the remaining computing devices 522" may be disposed on the rear of the board body 521. This structure of the electronic board 52" of one or more embodiments may distribute computing devices 522" having a relatively high heat generation among electronic components installed on the board body 521 onto both sides of the board body 521, thereby reducing or minimizing the challenge that the heat generated by the computing devices 522" being concentrated on one of the sides.

For example, as shown in FIG. 13, other electronic components (e.g., the computing devices 522" or networking devices 523"), which are to be disposed within a certain distance from electronic components (e.g., the computing devices 522") disposed on one side of the board body 521, may be disposed on the other side of the board body 521. Using this structure of the electronic board 52" of one or more embodiments may, even when multiple electronic components are mounted on the board body 521, increase the distance between the electronic components positioned on either side of the board body 521, which may be advantageous in distributing or dissipating heat generated between the electronic components.

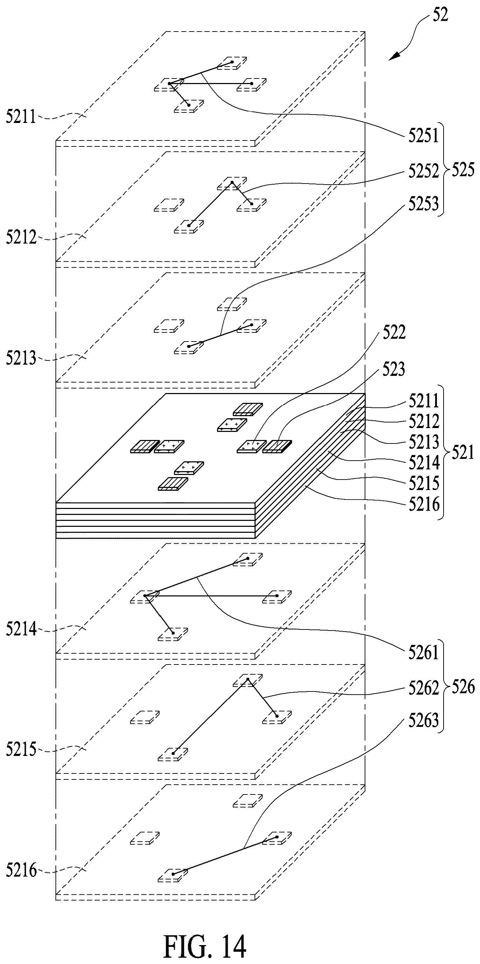

FIG. 14 illustrates an example of an electronic board according to one or more embodiments.

Referring to FIG. 14, an electronic board 52 of one or more embodiments may include a board body 521, a computing device 522, a networking device 523, an external connector (see 524 in FIG. 10), a first wiring 525, and a second wiring 526.

In one or more embodiments, the board body 521 may include a plurality of body layers 5211, 5212, 5213, 5214, 5215, and 5216 (or simply 5211 to 5216) stacked on top of each other, and a via structure (not shown) through at least some of the plurality of body layers 5211 to 5216. Although separate body layers (e.g., the plurality of body layers 5211 to 5216) are described by way of example, it will be appreciated by those of ordinary skill in the art that both sides of a single body layer may function as a plurality of body layers. It should also be appreciated that, unless otherwise noted, both sides of the same body layer are included in a plurality of body layers. The via structure may be a conductive material that penetrates at least a portion of the body layers and is connected to a connection pad to which electronic components (e.g., a plurality of computing devices 522 or networking devices 523) disposed on the board body 521 are connected. For example, each electronic component may be connected to a plurality of connection pads on the board body 521 in various ways, such as, a ball grid array (BGA) structure, a land grid array (LGA) structure, or a lead frame structure. This structure and configuration of the electronic board 52 of one or more embodiments may distribute the first wiring 525 and the second wiring 526 across the plurality of body layers 5211 to 5216, while allowing the via structure to connect each wiring to the electronic components, thereby simplifying the design of the wiring and shortening the length of wiring that connects each electronic component.

For example, in the first body layer 5211, a first computing wiring 5251 that is connected from a first computing device 522, which is one of the plurality of computing devices 522, to each of the other computing devices 522 may be formed.

For example, in the second body layer 5212, a second computing wiring 5252 that is connected from a second computing device 522, which is another one of the plurality of computing devices 522, to each of the other computing devices 522, and does not overlap the first computing wiring 5251 may be formed.

Similarly, in the third body layer 5213, a third computing wiring 5253 that does not overlap the first computing wiring 5251 and the second computing wiring 5252 may be formed.

In the same manner as the computing wiring 525 described above, the fourth body layer 5214, the fifth body layer 5215, and the sixth body layer 5216 may have a first networking wiring 5261, a second networking wiring 5262, and a third networking wiring 5263 formed respectively. The computing wiring 525 and/or networking wiring 526 of the electronic board 52 of one or more embodiments formed in this manner may interconnect a plurality of radially disposed electronic components, with shortened lengths thereof, while avoiding interference with each other.

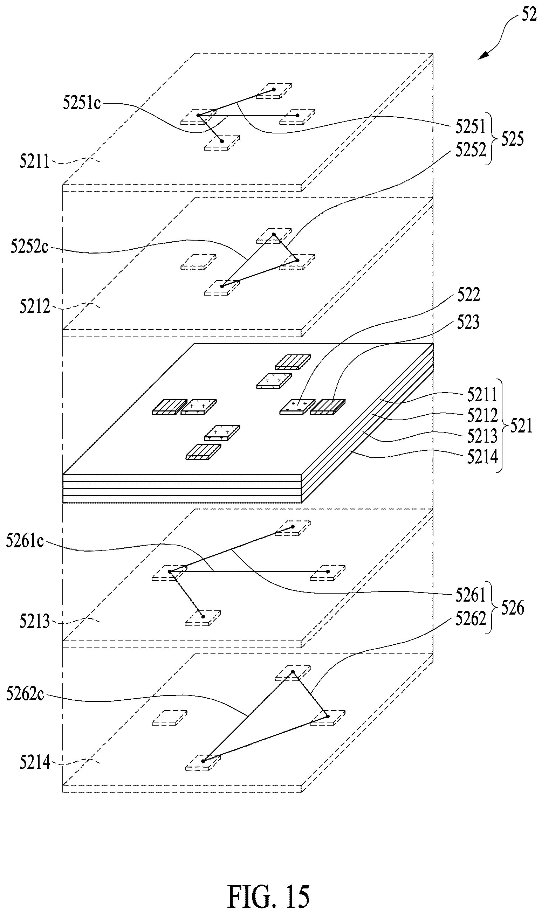

FIG. 15 illustrates an example of an electronic board according to one or more embodiments.

Referring to FIG. 15, an electronic board 52 of one or more embodiments may include a board body 521, a computing device 522, a networking device 523, an external connector (see 524 in FIG. 10), a first wiring 525, and a second wiring 526. The board body 521 may include a plurality of body layers 5211, 5212, 5213, and 5214 (or simply 5211 to 5214) stacked on top of each other, and a via structure (not shown) through at least some of the plurality of body layers 5211 to 5214.

The first wiring 525 may be distributed across the plurality of body layers 5211 to 5214. For example, the first wiring 525 may include a first computing wiring 5251 formed in the first body layer 5211 and a second computing wiring 5252 formed in the second body layer 5212.

The first computing wiring 5251 may include a first computing crosswire 5251c that is formed in the first body layer 5211 and interconnects a first pair of computing devices 522 positioned opposite each other relative to one point (e.g., a center of the board body 521) of the plurality of computing devices 522. For example, the first computing crosswire 5251c may be the longest wire of the first computing wiring 5251. It should also be appreciated that, unlike the example of FIG. 15, as the number of computing devices 522 increases, a plurality of computing crosswires with different lengths may be formed within a single body layer.

The second computing wiring 5252 may include a second computing crosswire 5252c that is formed in the second body layer 5212 and interconnects a second pair of computing devices 522 positioned opposite each other relative to the point of the plurality of computing devices 522.

The first computing crosswire 5251c and/or the second computing crosswire 5252c described above may be connected to the first pair of computing devices 522 or the second pair of computing devices 522 via the via structure. As such, by forming, in different body layers (e.g., 5251 and 5252), a wire (also referred to herein as a "computing crosswire" (e.g., 5251c and 5252c)) that connects a pair of computing devices 522 disposed opposite each other relative to one point that is a center of a radial arrangement of the plurality of computing devices 522, the electronic board 52 of one or more embodiments may enable a relatively unconstrained arrangement of the remaining portion of the first wiring 525. For example, as shown in FIG. 15, the first wiring 525, except for the computing crosswires 5251c and 5252c, may be divided and formed on the respective body layers 5251and 5252 in which the computing crosswires 5251c and 5252c are distributed, and the electronic board 52 of one or more embodiments may thereby reduce the number of required body layers and reduce the overall thickness of the electronic board 52.

The second wiring 526 may be distributed across the plurality of body layers 5211 to 5214. For example, the second wiring 526 may include a first networking wiring 5261 formed in the third body layer 5213 and a second networking wiring 5262 formed in the fourth body layer 5214.

The first networking wiring 5261 may include a first networking crosswire 5261c that is formed in the third body layer 5213 and interconnects a first pair of networking devices 523 positioned opposite each other relative to one point of the plurality of networking devices 523.

The second networking wiring 5262 may include a second networking crosswire 5262c that is formed in the fourth body layer 5214 and interconnects a second pair of networking devices 523 positioned opposite each other relative to the one point of the plurality of networking devices 523.

Unless otherwise noted, the method of forming the computing crosswires 5251c and 5252c and the remaining portion of the first wiring 525 described above may apply to the method of forming the networking crosswires 5261c and 5262c and the remaining portion of the second wiring 526, and a detailed and repeated description thereof will be omitted.

It may be verified that the structure described above may reduce the number of body layers (e.g., 5211 to 5214), compared to the example embodiment described with reference to FIG. 14.

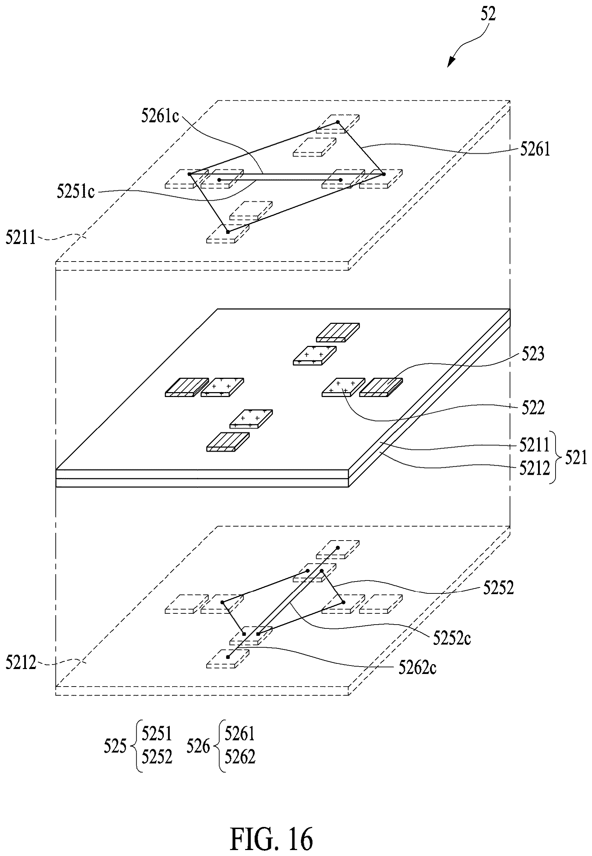

FIG. 16 illustrates an example of an electronic board according to one or more embodiments.

Referring to FIG. 16, an electronic board 52 of one or more embodiments may include a board body 521, a computing device 522, a networking device 523, an external connector (see 524 in FIG. 10), a computing wiring 525, and a networking wiring 526. The board body 521 may include a plurality of body layers 5211 and 5212 stacked on top of each other, and a via structure (not shown) through at least some of the plurality of body layers 5211and 5212.

In one or more embodiments, the computing wiring 525 and the networking wiring 526 may be formed in the same body layer.

For example, the computing wiring 525 may include a first computing wiring 5251 formed in the first body layer 5211 and a second computing wiring 5252 formed in a second body layer 5212. The first computing wiring 5251 may include a first computing crosswire 5251c. The second computing wiring 5252 may include a second computing crosswire 5252c.

For example, the networking wiring 526 may include a first networking wiring 5261 formed in the first body layer 5211 and a second networking wiring 5262 formed in the second body layer 5212. The first networking wiring 5261 may include a first networking crosswire 5261c. The second networking wiring 5262 may include a second networking crosswire 5262c.

As shown in FIG. 16, the first computing crosswire 5251c and the first networking crosswire 5261c may be formed at substantially the same height in the first body layer 5211. When some of these two different types of wiring are formed in the same body layer, the total number of body layers (e.g., 5211 and 5212) may be reduced, compared to the other example embodiments described above.

For example, of the plurality of computing crosswires 5251c and 5252c, one computing crosswire 5251c may be formed in the same body layer 5211 as the networking crosswire 5261c that interconnects a pair of networking devices 523 nearest to each of a pair of computing devices 522 interconnected by the computing crosswire 5251c. For example, the first computing crosswire 5251c and the first networking crosswire 5261c may be disposed parallel to each other. This arrangement and structure of the electronic board 52 of one or more embodiments may improve the degree of freedom in designing the remaining portion of the wirings 525 and 526, thereby reducing the overall thickness of the board body 521.

Similarly, the second computing crosswire 5252c and the second networking crosswire 5262c may be formed at substantially the same height in the second body layer 5212. The second computing crosswire 5252c and the second networking crosswire 5262c may be disposed parallel to each other.

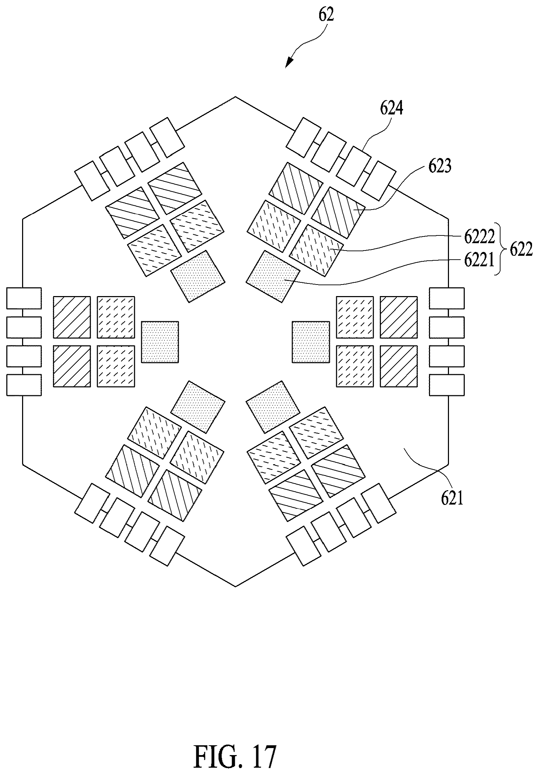

FIG. 17 illustrates an example of an electronic board according to one or more embodiments.

Referring to FIG. 17, an electronic board 62 of one or more embodiments may include a board body 621, a computing device 622, a networking device 623, and an external connector 624.

In one or more embodiments, each computing device 622 may include a central processing unit (CPU) 6221 and a plurality of graphics processing units (GPUs) 6222.

A plurality of CPUs 6221 may be disposed radially around one point (e.g., a center of the board body 621). A plurality of GPUs 6222 may be disposed radially around the point. For example, the CPU 6221 may be disposed nearer to the point than the plurality of GPUs 6222. This structure of the electronic board 62 of one or more embodiments may arrange the plurality of GPUs 6222 at a relatively greater distance from the one point than the CPU 6221, thereby enabling an efficient spatial arrangement in a case where the number of GPUs 6222 is greater than the number of CPUs 6221. In this case, by arranging a relatively small number of CPUs 6221 to be near the point, the electronic board 62 of one or more embodiments may reduce the wiring spacing between the plurality of CPUs 6221 while providing a sufficient space in which the GPUs 6222 are to be disposed.

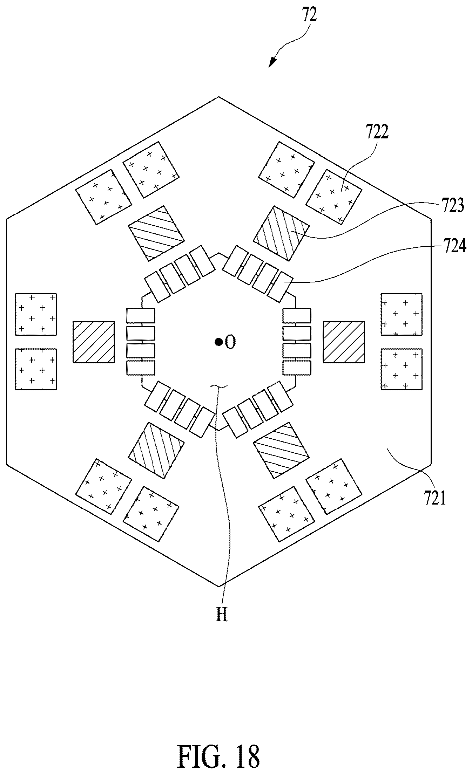

FIG. 18 illustrates an example of an electronic board according to one or more embodiments.

Referring to FIG. 18, an electronic board 72 of one or more embodiments may include a board body 721, a computing device 722, a networking device 723, and an external connector 724.

In one or more embodiments, the board body 721 may have a hole H formed therein through which an external cable (e.g., see 23 in FIG. 7) may pass. The hole H may also be referred to as a "cable hole." This structure and configuration of the electronic board 72 of one or more embodiments may allow the external cable to pass through the hole H between a plurality of electronic boards to be connected to the external connector 724.

In one or more embodiments, a plurality of computing devices 722 may be positioned farther from a point O than a plurality of networking devices 723, and a plurality of external connectors 724 may be positioned nearer to the point O than the plurality of networking devices 723. For example, the plurality of networking devices 723 may be disposed between the plurality of computing devices 722 and the plurality of external connectors 724, and may be disposed radially around the point O. For example, the plurality of external connectors 724 may be disposed along a circumferential direction of the hole H. That is, the external connectors 724 may be disposed along an inner boundary of the board body 721. This structure of the electronic board 72 of one or more embodiments may be advantageous in terms of space utilization when the number of computing devices 722 is greater than the number of networking devices 723. In another example, in addition to the plurality of networking devices 723 and the plurality of external connectors 724 shown in FIG. 18, the electronic board 72 may further include other networking devices (e.g., the networking devices 223 of FIG. 3) disposed along an outer circumferential direction of the plurality of computing devices 722 and other external connectors (e.g., the external connectors 224 of FIG. 3) disposed along a circumferential direction of the other networking devices.

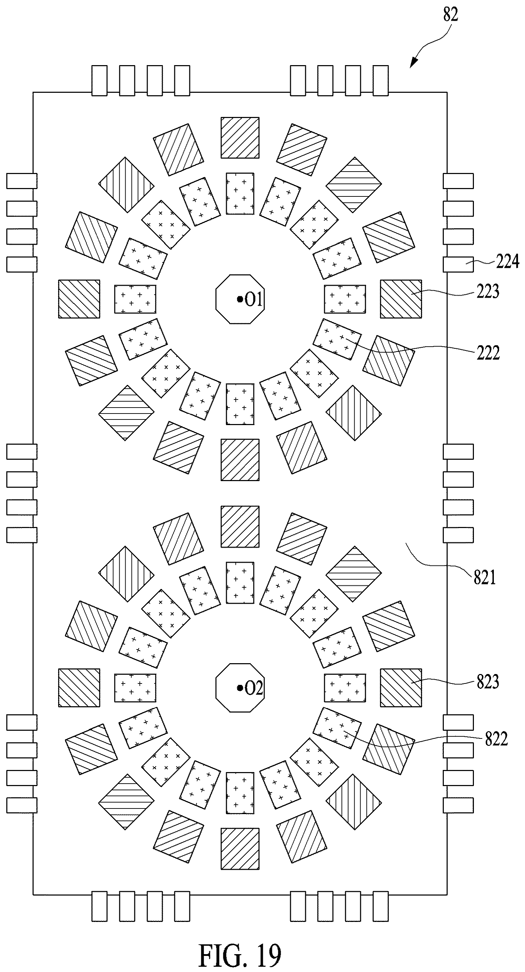

FIG. 19 illustrates an example of an electronic board according to one or more embodiments.

Referring to FIG. 19, an electronic board 82 of one or more embodiments may include a plurality of electronic components disposed radially around a plurality of points O1 and O2. The electronic board 82 may include a board body 821, a computing device 222, a networking device 223, an external connector224, an additional computing device 822, and an additional networking device 823.

It should be appreciated that the board body 821 may have a shape (e.g., a rectangular shape) that is elongated on one side to conform to the shape in which all the electronic components are disposed, but is not limited thereto. For example, the board body 821 may also be formed in a shape (e.g., number "8") in which a plurality of circles (e.g., regular circles or ellipses) or polygons (e.g., regular polygons) overlap each other such that a distance from each of the networking device 223 and the additional networking devices 823 to the external connector 224 nearest thereto may be reduced.

A plurality of computing devices 222 and a plurality of networking devices 223 may be disposed radially around a first point O1.

A plurality of additional computing devices 822 and a plurality of additional networking devices 823 may be disposed radially around a second point O2 that is different from the first point O1 described above.

For example, a distance from the first point O1 to the plurality of computing devices 222 and a distance from the second point O2 to the plurality of additional computing devices 822 may be the same, but examples are not limited thereto. For example, a distance from the first point O1 to the plurality of networking devices 223 and a distance from the second point O2 to the plurality of additional networking devices 823 may be the same, but examples are not limited thereto.

A plurality of external connectors 224 may be disposed radially, for example, along an outer boundary of the board body 821. **It** should be appreciated that the external connectors 224 may also be disposed along the hole H corresponding to an inner boundary of the board body 821. For example, it should also be appreciated that, to reduce the distance from each networking device 223 to the nearest external connector 224, some of the plurality of external connectors 224 may be disposed on the outer boundary of the board body 821, while others may be disposed on the inner boundary of the board body 821.

The computing systems, cases, electronic boards, external cables, board bodies, computing devices, networking devices, external connectors, first cables, second cables, third cables, first wirings, second wirings, internal connectors, cooling plates, plate bodies, inlet ports, outlet ports, cooling channels, first regions, second regions, body layers, first computing wirings, second computing wirings, third computing wirings, first networking wirings, second networking wirings, third networking wirings, first computing crosswires, second computing crosswires, first networking crosswires, second networking crosswires, CPUs, GPUs, additional computing devices, additional networking devices, computing system 1, case 11, electronic boards 12, external cables 13, board body 121, computing device 122, networking device 123, external connector 124, first cable 131, second cable 132, third cable 133, electronic board 22, board body 221, computing device 222, networking device 223, external connector 224, first wiring 225, second wiring 226, electronic board 32, board body 321, computing device 322, networking device 323, external connector 324, internal connector 327, computing system 2, case 21, electronic board 22, external cable 23, cooling plate 24, plate body 241, inlet port 242, outlet port 243, cooling channel 244, first region 2441, second region 2442, electronic board 42, board body 421, computing device 422, networking device 423, external connector 424, electronic board 52, board body 521, computing device 522, networking device 523, external connector 524, first wiring 525, second wiring 526, electronic board 52', networking device 523', computing device 522", networking device 523", body layers 5211, 5212, 5213, 5214, 5215, and 5216, first computing wiring 5251, second computing wiring 5252, third computing wiring 5253, first networking wiring 5261, second networking wiring 5262, third networking wiring 5263, first computing crosswire 5251c, second computing crosswire 5252c, first networking crosswire 5261c, second networking crosswire 5262c, electronic board 62, board body 621, computing device 622, networking device 623, external connector 624, CPU 6221, GPUs 6222, electronic board 72, board body 721, computing device 722, networking device 723, external connector 724, electronic board 82, board body 821, additional computing device 822, and additional networking device 823 described herein, including descriptions with respect to respect to FIGS. 1-19, are implemented by or representative of hardware components. As described above, or in addition to the descriptions above, examples of hardware components that may be used to perform the operations described in this application where appropriate include controllers, sensors, generators, drivers, memories, comparators, arithmetic logic units, adders, subtractors, multipliers, dividers, integrators, and any other electronic components configured to perform the operations described in this application. In other examples, one or more of the hardware components that perform the operations described in this application are implemented by computing hardware, for example, by one or more processors or computers. A processor or computer may be implemented by one or more processing elements, such as an array of logic gates, a controller and an arithmetic logic unit, a digital signal processor, a microcomputer, a programmable logic controller, a field-programmable gate array, a programmable logic array, a microprocessor, or any other device or combination of devices that is configured to respond to and execute instructions in a defined manner to achieve a desired result. In one example, a processor or computer includes, or is connected to, one or more memories storing instructions or software that are executed by the processor or computer. Hardware components implemented by a processor or computer may execute instructions or software, such as an operating system (OS) and one or more software applications that run on the OS, to perform the operations described in this application. The hardware components may also access, manipulate, process, create, and store data in response to execution of the instructions or software. For simplicity, the singular term "processor" or "computer" may be used in the description of the examples described in this application, but in other examples multiple processors or computers may be used, or a processor or computer may include multiple processing elements, or multiple types of processing elements, or both. For example, a single hardware component or two or more hardware components may be implemented by a single processor, or two or more processors, or a processor and a controller. One or more hardware components may be implemented by one or more processors, or a processor and a controller, and one or more other hardware components may be implemented by one or more other processors, or another processor and another controller. One or more processors, or a processor and a controller, may implement a single hardware component, or two or more hardware components. As described above, or in addition to the descriptions above, example hardware components may have any one or more of different processing configurations, examples of which include a single processor, independent processors, parallel processors, single-instruction single-data (SISD) multiprocessing, single-instruction multiple-data (SIMD) multiprocessing, multiple-instruction single-data (MISD) multiprocessing, and multiple-instruction multiple-data (MIMD) multiprocessing.

The methods illustrated in, and discussed with respect to, FIGS. 1-19 that perform the operations described in this application are performed by computing hardware, for example, by one or more processors or computers, implemented as described above implementing instructions (e.g., computer or processor/processing device readable instructions) or software to perform the operations described in this application that are performed by the methods. For example, a single operation or two or more operations may be performed by a single processor, or two or more processors, or a processor and a controller. One or more operations may be performed by one or more processors, or a processor and a controller, and one or more other operations may be performed by one or more other processors, or another processor and another controller. One or more processors, or a processor and a controller, may perform a single operation, or two or more operations.

Instructions or software to control computing hardware, for example, one or more processors or computers, to implement the hardware components and perform the methods as described above may be written as computer programs, code segments, instructions or any combination thereof, for individually or collectively instructing or configuring the one or more processors or computers to operate as a machine or special-purpose computer to perform the operations that are performed by the hardware components and the methods as described above. **In** one example, the instructions or software include machine code that is directly executed by the one or more processors or computers, such as machine code produced by a compiler. In another example, the instructions or software includes higher-level code that is executed by the one or more processors or computer using an interpreter. The instructions or software may be written using any programming language based on the block diagrams and the flow charts illustrated in the drawings and the corresponding descriptions herein, which disclose algorithms for performing the operations that are performed by the hardware components and the methods as described above.

The instructions or software to control computing hardware, for example, one or more processors or computers, to implement the hardware components and perform the methods as described above, and any associated data, data files, and data structures, may be recorded, stored, or fixed in or on one or more non-transitory computer-readable storage media, and thus, not a signal per se. As described above, or in addition to the descriptions above, examples of a non-transitory computer-readable storage medium include one or more of any of read-only memory (ROM), random-access programmable read only memory (PROM), electrically erasable programmable read-only memory (EEPROM), random-access memory (RAM), dynamic random access memory (DRAM), static random access memory (SRAM), flash memory, non-volatile memory, CD-ROMs, CD-Rs, CD+Rs, CD-RWs, CD+RWs, DVD-ROMs, DVD- Rs, DVD+Rs, DVD-RWs, DVD+RWs, DVD-RAMs, BD-ROMs, BD-Rs, BD-R LTHs, BD-REs, blue-ray or optical disk storage, hard disk drive (HDD), solid state drive (SSD), flash memory, a card type memory such as multimedia card micro or a card (for example, secure digital (SD) or extreme digital (XD)), magnetic tapes, floppy disks, magneto-optical data storage devices, optical data storage devices, hard disks, solid-state disks , and/or any other device that is configured to store the instructions or software and any associated data, data files, and data structures in a non-transitory manner and provide the instructions or software and any associated data, data files, and data structures to one or more processors or computers so that the one or more processors or computers can execute the instructions. In one example, the instructions or software and any associated data, data files, and data structures are distributed over network-coupled computer systems so that the instructions and software and any associated data, data files, and data structures are stored, accessed, and executed in a distributed fashion by the one or more processors or computers.

While this disclosure includes specific examples, it will be apparent after an understanding of the disclosure of this application that various changes in form and details may be made in these examples without departing from the scope of the claims . The examples described herein are to be considered in a descriptive sense only, and not for purposes of limitation. Descriptions of features or aspects in each example are to be considered to be applicable to similar features or aspects in other examples. Suitable results may be achieved if the described techniques are performed in a different order, and/or if components in a described system, architecture, device, or circuit are combined in a different manner, and/or replaced or supplemented by other components or their equivalents.

Therefore, in addition to the above disclosure, the scope of the present invention is defined by the enclosed claims.

## Claims

1. An electronic board, comprising:
a board body having a circuit formed therein;
a plurality of computing devices disposed at a position between a first distance and a second distance from one point of the board body, and arranged radially around the one point;
a plurality of networking devices disposed at a position between the second distance and a third distance from the one point of the board body, and arranged radially around the one point; and
a plurality of external connectors arranged radially along a boundary of the board body, to which external cables interconnecting the electronic board and other electronic boards are configured to be connected.

2. The electronic board of claim 1, wherein
the one point is a center of the board body, and
the board body has a shape with point symmetry relative to the one point.

3. The electronic board of claim 1 or 2, wherein
the plurality of computing devices is disposed nearer to the one point than the plurality of networking devices,
the plurality of external connectors is disposed farther from the one point than the plurality of networking devices, and.
the electronic board preferably further comprises a heat release hole formed at the one point.

4. The electronic board of one of claims 1 to 3, further comprising,
a plurality of internal connectors disposed between the plurality of computing devices and the plurality of networking devices, and arranged radially around the one point; and
an internal cable interconnecting a pair of internal connectors of the plurality of internal connectors.

5. The electronic board of one of claims 1 to 4, wherein
of the plurality of computing devices, a pair of computing devices disposed on opposite sides from the one point is electrically connected by a cable fastened to an outer surface of the board body, and
any one of the pair of computing devices and any one of the plurality of computing devices other than the pair of computing devices are electrically connected by the circuit formed inside the board body.

6. The electronic board of one of claims 1 to 5, wherein, of the plurality of computing devices and the plurality of networking devices, some devices are disposed on a front side of the board body and remaining devices are disposed on a rear side of the board body,
wherein, of the plurality of computing devices, some computing devices are preferably disposed on the front side of the board body and remaining computing devices are preferably disposed on the rear side of the board body.

7. The electronic board of one of claims 1 to 6, comprising:
a computing wiring that connects the plurality of computing devices and is formed on either one of a front side and a rear side of the board body; and
a networking wiring that connects the plurality of networking devices and is formed on a side, of the front side and the rear side of the board body, on which the computing wiring is not formed.

8. The electronic board of one of claims 1 to 7, wherein
the board body comprises a plurality of body layers stacked on top of each other and a via structure through one or more of the plurality of body layers,
the electronic board further comprises:
a first computing crosswire that, of the plurality of computing devices, interconnects a first pair of computing devices disposed opposite each other relative to the one point and is formed in a first body layer of the plurality of body layers; and
a second computing crosswire that, of the plurality of computing devices, interconnects a second pair of computing devices disposed opposite each other relative to the one point and is formed in a second body layer of the plurality of body layers, and
either one of the first computing crosswire and the second computing crosswire is connected to either one of the first pair of computing devices and the second pair of computing devices by the via structure.

9. The electronic board of claim 8, further comprising:
a first networking crosswire that, of the plurality of networking devices, interconnects a first pair of networking devices disposed opposite each other relative to the one point; and
a second networking crosswire that, of the plurality of networking devices, interconnects a second pair of networking devices disposed opposite each other relative to the one point,
wherein the first computing crosswire and the first networking crosswire are formed at substantially the same height in the first body layer,
wherein the second computing crosswire and the second networking crosswire are formed at substantially the same height in the second body layer, and
wherein any one of the computing crosswires is preferably formed on the same body layer as a networking crosswire that interconnects a pair of networking devices nearest respectively to a pair of computing devices interconnected by the one computing crosswire.

10. The electronic board of one of claims 1 to 9, wherein
the board body comprises a plurality of body layers stacked on top of each other and a via structure through one or more of the plurality of body layers,
the electronic board further comprises:
a first networking crosswire that, of the plurality of computing devices, interconnects a first pair of networking devices disposed opposite each other relative to the one point and is formed in a first body layer of the plurality of body layers; and
a second networking crosswire that, of the plurality of computing devices, interconnects a second pair of networking devices disposed opposite each other relative to the one point and is formed in a second body layer of the plurality of body layers, and
either one of the first networking crosswire and the second networking crosswire is connected to either one of the first pair of networking devices and the second pair of networking devices by the via structure.

11. The electronic board of one of claims 1 to 10, wherein one or more of the plurality of computing devices comprises a central processing unit, CPU, and a plurality of graphics processing units, GPUs, the CPU being disposed nearer to the one point than the plurality of GPUs, or
wherein the electronic board further comprises a cable hole through which the external cables are configured to pass, the plurality of computing devices being disposed farther from the one point than the plurality of networking devices, and the plurality of external connectors being disposed along a circumferential direction of the cable hole, or
wherein the board body has a regular polygonal shape, and the plurality of external connectors is distributed in equal numbers along each side of the board body.

12. The electronic board of one of claims 1 to 11, further comprising:
a plurality of additional computing devices arranged radially around another point of the board body; and
a plurality of additional networking devices arranged radially around the other point of the board body.

13. The electronic board of claim 1, wherein:
the board body has a shape with point symmetry of either one of a polygonal shape and a circular shape;
the plurality of computing devices is arranged along a circumferential direction of an imaginary first circle having a first radius relative to the one point on the board body;
the plurality of networking devices is arranged along a circumferential direction of an imaginary second circle having a second radius relative to the one point on the board body; and
the plurality of external connectors is arranged along a circumferential direction of an imaginary third circle having a third diameter relative to the one point on the board body.

14. A computing system, comprising:
a case having a receiving space formed therein;
a plurality of electronic boards disposed within the receiving space; and
a plurality of external cables interconnecting two or more of the plurality of electronic boards,
wherein one or more of the plurality of electronic boards are arranged according to one of claims 1 to 13.

15. The computing system of claim 14, further comprising:
a cooling plate disposed between the plurality of electronic boards,
wherein the cooling plate comprises:
a plate body having a cooling channel formed therein;
an inlet port configured to receive a cooling fluid and direct the received cooling fluid into the cooling channel; and
an outlet port configured to direct the cooling fluid from the cooling channel to the outside to discharge the cooling fluid to the outside,
wherein the cooling channel comprises:
a first region overlapping the plurality of computing devices in a direction perpendicular to the plurality of electronic boards; and
a second region overlapping the plurality of networking devices in the direction perpendicular to the plurality of electronic boards, and
wherein the cooling fluid flows in sequential order from the inlet port, the first region, the second region, to the outlet port.
